# EUROPEAN PATENT SPECIFICATION

(11) **EP 3 697 943 B1**
(45) Date of publication and mention of the grant of the patent: **14.02.2024**
(21) Application number: 18869272.7
(22) Date of filing: 17.10.2018
(51) Int. Cl.: C23C 16/455

(54) **NOZZLE HEAD**
DÜSENKOPF
TÊTE DE BUSE

(30) Priority: 18.10.2017 FI 20175918
(43) Date of publication of application: 26.08.2020
(73) Proprietor: Beneq OY, 02200 Espoo (FI)
(72) Inventor: SOININEN, Pekka, 02200 Espoo (FI); JAUHIAINEN, Mika, 02200 Espoo (FI)
(74) Representative: Primrose Oy
(86) International application number: PCT/FI2018/050755
(87) International publication number: WO 2019/077204

(56) References cited:
- WO-A2-2016/072850
- US-A1- 2002 197 402
- US-A1- 2005 092 249
- US-A1- 2011 023 775
- US-A1- 2011 023 775
- US-A1- 2015 007 770
- US-A1- 2015 007 770

## Description

### FIELD OF THE INVENTION

The present invention relates to a nozzle head for subjecting a surface of a substrate to successive surface reactions of at least two precursor gases according to the principles of atomic layer deposition and more particularly to a nozzle head according to the preamble of the independent claim 1.

### BACKGROUND OF THE INVENTION

Nozzle heads are commonly used in atomic layer deposition (ALD) for subjecting a surface of the substrate to successive surface reactions of at least two precursor gases. The nozzle head comprises an output face via which precursor gases are supplied towards the substrate. The output face is provided with two or more nozzles from which the precursor gases are supplied. In this kind of spatial ALD processes the precursor gases are separated in space. With careful management of gas flow and by applying relative movement between the substrate and spatially separated gasses, it is possible to apply the coating continuously on moving substrates at high speeds. During the spatial ALD process the nozzle head is moved over the surface of the substrate such that there is small gap between the output face and the surface of the substrate. The gap between the output face and the surface of the substrate must be managed in detail such that the gap is as equal as possible during processing. Therefore, both the relative movement of the nozzle head and the substrate and the dimensions and shape of the nozzle head must be controlled in detail for keeping the gap as equal as possible.

The precursor gases and purge gas that is used for separating different precursor gases are typically supplied from a source outside the nozzle head with separate supply channels to precursor nozzles in a nozzle head. As the nozzle head is moved over the substrate either in a planar movement, in an oscillating or pendulum movement the connections between the supply channels and the nozzles are also moving together with nozzle head which makes the controlling of the connections challenging.

The process temperature is usually 50 - 150 °C and the nozzle head is also heated to the process temperature in order to control the process in great detail. The process temperature may in same cases be even 300 °C or 350 °C or even more. These elevated process temperatures cause thermal expansion in the nozzle head and in the surrounding structures of the nozzle head in the whole process apparatus. The thermal expansion becomes greater as the process temperature increases. The thermal expansion causes the dimensions of the nozzle head to change and it may also cause distortions to the shape and dimensions of the nozzle.

Publication US 2011/023775 discloses an apparatus for atomic layer deposition of a material on a moving substrate comprising a coating bar having at least one precursor delivery channel. Publication US 2015/007770 discloses a dual-temperature, multi-plenum showerhead for use in semiconductor processing equipment.

One of the problems associated with the prior art is that as the nozzle head moves in elevated temperatures the connections of the separate supply channels of the precursor gases in the nozzles are also affected by the elevated temperatures. A nozzle head comprises multiple nozzles and as every nozzle may comprise one or more supply channel connections the exterior of the nozzle head is surrounded by multiple channels which have to be moved together with the moving nozzle head.

### BRIEF DESCRIPTION OF THE INVENTION

An object of the present invention is to provide a nozzle head having more simple structure which can be used in elevated process temperatures and is adapts better to the movement of the nozzle head.

The objects of the invention are achieved by a nozzle head which is characterized by what is stated in the independent claim. The preferred embodiments of the invention are disclosed in the dependent claims.

The invention is based on the idea of providing a nozzle head in which the gas supply to the nozzles is structurally simplified in order to provide better control for the supply in a moving nozzle head and especially in elevated temperatures.

The nozzle head according to the invention comprises a body, an output face via which at least one precursor gas is supplied towards the surface of the substrate and two or more nozzles provided in connection with the output face for supplying the at least one precursor gas. The nozzle head further comprises a nozzle head chamber inside the body of the nozzle head. The nozzle head chamber is arranged in fluid communication with the two or more nozzles such that gas provided inside the nozzle head chamber can be supplied from the nozzle head chamber through gas passages between the two or more nozzles and via output face to the surface of the substrate. The nozzle head chamber is provided with a gas inlet for supplying gas into the nozzle head chamber from a gas source outside the nozzle head.

The two or more nozzles may be arranged to form at least part of a bottom wall of the nozzle head chamber.

The body comprises a first side structure, a second side structure, a first end structure and a second end structure, and that the two or more nozzles are arranged to extend between the first and second end structures and arranged adjacent to each other in a direction between the first and second side structures. The nozzle head chamber is arranged inside the body of the nozzle head. The two or more nozzles are arranged to form at least part of a bottom wall of the nozzle head chamber, and the first side structure, the second side structure, the first end structure and the second end structure of the body are arranged to form side walls of the nozzle head chamber. The body further comprises a top structure forming a top wall of the nozzle head chamber.

The nozzle head chamber comprises a first precursor conduit for distributing first precursor gas to at least one of the two or more nozzles. The first precursor conduit is preferably arranged to distribute first precursor gas to at least two nozzles, said precursor conduit is a branching conduit having a connection with said at least two nozzles. The nozzle head comprises a first precursor gas connection for connecting a first precursor channel arranged outside the nozzle head and extending from a first precursor source with the first precursor conduit arranged inside the nozzle head chamber and extending to the at least one of the two or more nozzles. In other words, the nozzle head comprises a single first precursor gas connection connecting the first precursor channel that is outside the nozzle head and connected to the first precursor source with the first precursor conduit arranged inside the nozzle head chamber and branching inside the nozzle head chamber into multiple conduits connecting to multiple nozzles for supplying first precursor gas from the first precursor source to the nozzles and through the nozzles via output face to the surface of a substrate. The first precursor gas connection is preferably arranged in the top structure of the body of the nozzle head, i.e. in the top wall of the nozzle head chamber. Alternatively, the first precursor gas connection is provided in one of the side walls of the nozzle head chamber.

The nozzle head may be arranged such that the at least two or more nozzles are facing downwards such that the substrate to be coated is below the nozzle head or alternatively the nozzle head may be arranged such that the at least two or more nozzles are facing upwards and the substrate to be coated is above the nozzle head. In the first case the top structure of the body is upper in the nozzle head than the nozzles in a height direction of the nozzle head and in the second case the top structure of the body is lower in the nozzle head than the nozzles in the height direction of the nozzle head.

The nozzle head chamber comprises a second precursor conduit for distributing second precursor gas to at least one of the two or more nozzles. The second precursor conduit is preferably arranged to distribute second precursor gas to at least two nozzles. The nozzle head comprises a second precursor gas connection for connecting a second precursor channel arranged outside the nozzle head and extending from a second precursor source with the second precursor conduit arranged inside the nozzle head chamber and extending to the at least one of the two or more nozzles. In other words, the nozzle head comprises a single second precursor gas connection connecting the second precursor channel that is outside the nozzle head and connected to the second precursor source with the second precursor conduit arranged inside the nozzle head chamber and branching inside the nozzle head chamber into multiple conduits connecting to multiple nozzles for supplying second precursor gas from the second precursor source to the nozzles and through the nozzles via output face to the surface of a substrate The second precursor conduit, as well as the first precursor conduit, is a branching conduit such that the conduit has a single connection to the precursor gas connection and inside the nozzle head chamber it is divided into several branches such that the precursor conduit is connected with multiple connections to the multiple nozzles. The second precursor gas connection is preferably arranged in the top structure of the body of the nozzle head, i.e. in the top wall of the nozzle head chamber. Alternatively, the second precursor gas connection is provided in one of the side walls of the nozzle head chamber.

In a case where there are more than the first precursor and the second precursor similar conduits are provided for those precursors too.

Preferably the nozzle head comprises multiple nozzles such that the first precursor conduit is arranged to distribute first precursor gas to at least two precursor nozzles and the second precursor conduit is arranged to distribute second precursor gas also to at least two precursor nozzles which are different than those distributed with the first precursor. In other words, the nozzle head comprises at least two first precursor nozzles and at least two second precursor nozzles such that the first precursor conduit is arranged to distribute first precursor gas to the at least two first precursor nozzles and the second precursor conduit is arranged to distribute second precursor gas to at least two second precursor nozzles.

The gas inlet for supplying gas into the nozzle head chamber from a gas source outside the nozzle head is arranged to form a gas connection with a gas channel arranged outside the nozzle head and extending between the gas inlet and the gas source. The gas inlet is arranged to provide a fluid connection between the gas source and the nozzle head chamber. The gas inlet is preferably provided in the top structure of the body of the nozzle head, i.e. in the top wall of the nozzle head chamber. Alternatively, the gas inlet is provided in one of the side walls of the nozzle head chamber. The gas inlet provides an access for the gas to the nozzle head chamber without any gas conduits. The gas inlet is arranged in the nozzle head chamber such that it provides a direct fluid connection from a channel outside the nozzle head chamber into the nozzle head chamber. The gas source connected to the gas channel is preferably a purge gas source such that the gas supplied from the gas source to the nozzle head chamber is purge gas, but the gas may also alternatively be precursor gas.

The nozzle head chamber further comprises a discharge conduit for discharging gases from the surface of the substrate through the output face of the nozzle head and through the at least one of the two or more nozzles. The discharge conduit is connected to a discharge system arranged outside the nozzle head. The nozzle head comprises a discharge gas connection for connecting a discharge channel arranged outside the nozzle head and extending from the discharge system with the discharge conduit arranged inside the nozzle head chamber. The discharge is in other words arranged to extend inside the nozzle head chamber between the discharge gas connection and the nozzles.

In a preferable embodiment of the invention the nozzle head comprises two or more first precursor nozzles for supplying first precursor gas and two or more second precursor nozzles for supplying second precursor gas.

An advantage of the invention is that by simplifying the structure of the nozzle head with the gas supply through the nozzle head chamber the need for sealing of multiple connections in nozzles especially when the nozzle head is arranged movable decreases. This is especially advantageous with nozzle heads that are used in elevated temperatures such as temperatures between 300 and 350 °C.

### BRIEF DESCRIPTION OF THE DRAWINGS

The invention is described in detail by means of specific embodiments with reference to the enclosed drawings, in which
Figure 1a shows a nozzle head according to the invention;
Figure 1b shows the nozzle head shown in figure 1a as seen from the output face;
Figure 1c shows a cross section along line A-A of the nozzle head shown in figure 1b;
Figure 2a shows another nozzle head according to the invention;
Figure 2b shows the nozzle head shown in figure 2a as seen from side;
Figure 2c shows a cross section along line B-B of the nozzle head shown in figure 2b; and
Figure 3 shows a detail of the nozzle head shown in figure 1a.

### DETAILED DESCRIPTION OF THE INVENTION

A nozzle head according to the invention is defined in the appended claims.

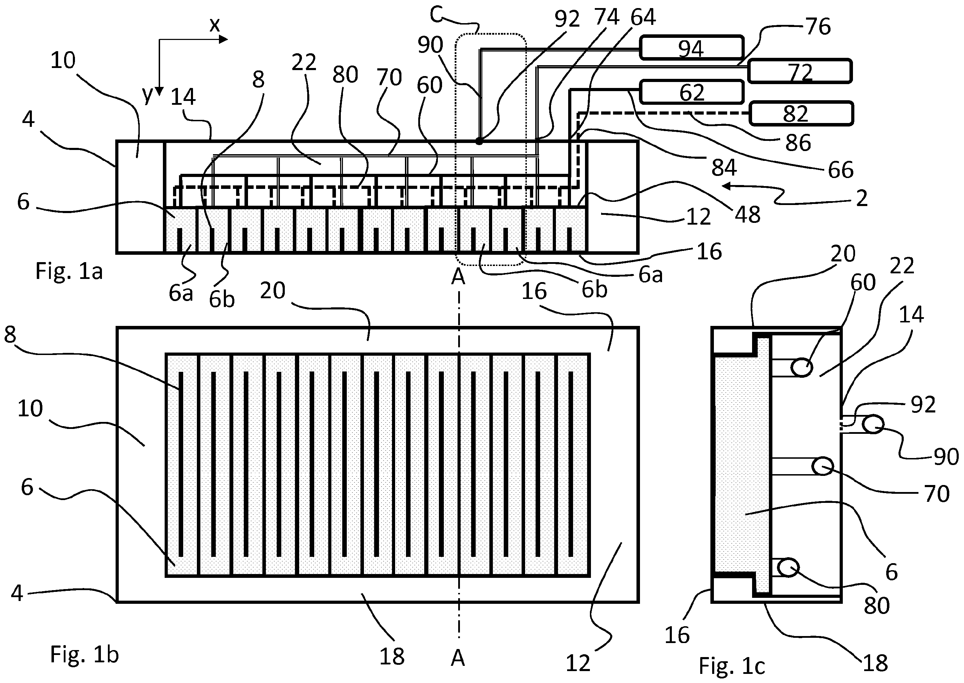

Figure 1a and 1b show a nozzle head 2 according to the invention which the nozzle head 2 comprises a body 4 which is formed of a first side structure 10, a second side structure 12 opposite to the first side structure 10 and a first end structure 18 and a second end structure 20 opposite to the first end structure 18 and a top structure 14. Opposite to the top structure 14 are two or more nozzles 6 which are arranged to extend between the first and second end structures 18, 20 and arranged adjacent to each other in a direction between the first and second side structures 10, 12. The nozzles 6 form an output face 16 via which at least one precursor gas is supplied towards the surface of the substrate. The figure 1a shows the nozzle head 2 as seen from side such that the output face 16 is facing downwards and the substrate to be coated (not shown in the figure) would be below the nozzle head 2.

In the context of this application it should be noted that a nozzle is a nozzle device into which gas is supplied and the nozzle device comprises a nozzle body and a nozzle opening from the which the gas discharges out of the nozzle.

The nozzle head chamber 22 is arranged inside the body 4 of the nozzle head 2. The nozzle head chamber 22 is formed of the first side structure 10, the second side structure 12 opposite to the first side structure 10 and the first end structure 18 and the second end structure 20 opposite to the first end structure 18 and the top structure 14 and the two or more nozzles are arranged to form at least part of a bottom wall of the nozzle head chamber 22. The nozzle head chamber 22 is arranged in fluid communication with the two or more nozzles 6 which means that gases in the nozzle head chamber 22 can flow from the nozzle head chamber 22 to the two or more nozzles 6 or vice versa.

The nozzle head chamber 22 is provided with a purge gas inlet 92 for supplying gas into the nozzle head chamber 22 from a gas source 94 outside the nozzle head 2. The purge gas inlet 92 is in the embodiment of the invention shown in figure 1a arranged in the top structure 14 of the nozzle head 2 such that gas supplied from the gas source 94 via a gas channel 90 is supplied from the top of the nozzle head chamber 22 to the nozzle head chamber 22. In other words, the purge gas inlet 92 comprises a gas supply opening which is open to the inner space of the nozzle head chamber.

In the embodiment shown in figure 1a the nozzle head chamber 22 is provided with a first precursor conduit 60, a second precursor conduit 70 and a discharge conduit 80 extending inside the nozzle head chamber 22 between the nozzles 6 and the respective gas connections 64, 74, 84. The first precursor conduit 60 for distributing first precursor gas to at least one of the two or more nozzles 6 is connected to the first precursor gas connection 64, the second precursor conduit 70 for distributing second precursor gas to at least one of the two or more nozzles 6 is connected to the second precursor gas connection 74 and the discharge conduit 80 for discharging gases from the surface of the substrate through the output face of the nozzle head 2 and through the at least one of the two or more nozzles 6 is connected to the discharge gas connection 84. The first precursor conduit 60 and the second precursor conduit 70 are branching conduits such that the conduit 60, 70 is connected with a single gas connection 64, 74 to the source 62, 72 arranged outside the nozzle head 2 and inside the nozzle head chamber 22 the conduit 60, 70 is divided into several branches for making connections with several nozzles 6 or alternatively for making several connections with several nozzles 6. In the embodiment shown in figure 1a the first precursor conduit 60 is connected with the branching conduits to the first precursor nozzles 6a and the second precursor conduit 70 is connected with the branching conduits to the second precursor nozzles 6b. The discharge conduit 80 is connected with all the nozzles 6 and extending from the nozzles 6 to the single discharge gas connection 84 on the top of the nozzle head chamber 22. There can also be two discharge conduits 80 connected with the nozzles 6. The first precursor source 62, the second precursor source 72, the purge gas source 94 and the discharge system 82 preferably comprising a pump or other discharging means are provided outside the nozzle head 2 and connected to the nozzle head 2 with channels 66, 76, 86, 90 extending between the nozzle head 2 and the sources 62, 72, 94 or between the nozzle head 2 and the system 82.

Figure 1c shows a cross section along line A-A of the nozzle head 2 shown in figure 1b. Figure 1c shows a detail of the nozzle head 22 in a line that is provided between two adjacent nozzles 6. The nozzle 6 is arranged to extend between the first and second end structures 18, 20. The nozzle head chamber 22 is provided with the first precursor conduit 60, the second precursor conduit 70 and the discharge conduit 80. In this figure, the shown nozzle 6 comprises a connection with the first precursor conduit 60 and the discharge conduit 80, the second precursor conduit 70 shown in the figure is connected to the nozzle 6 next to the nozzle 6 shown in this figure. The conduit 60 is arranged to extend in the nozzle head chamber 22 in a direction parallel to the nozzle top surface 48 which forms the bottom of the nozzle head chamber 22 and further arranged to branch into several branching conduits forming connection with the nozzles 6. The branching conduits extend in a direction that is substantially perpendicular to the nozzle top surface 48. The coordinates x, y in figure 1a are to illustrate the directions of the conduits and the output face of the nozzle head. When the output face 16 is substantially in the direction of x coordinate the main conduits from which the branching sub conduits are divided is also substantially in the direction of the x coordinate, i.e. parallel to the output face 16. The sub conduits that are divided from the main conduit, i.e. the branching conduits that are connected to the nozzles and that connect to the main conduit that is further connected to the gas connection are substantially in the direction of y coordinate, i.e. perpendicular to the output face 16. The purge gas inlet 92 is provided in the top structure 14 of the nozzle head 2 and connected with the purge gas channel 90 extending outside the nozzle head 2.

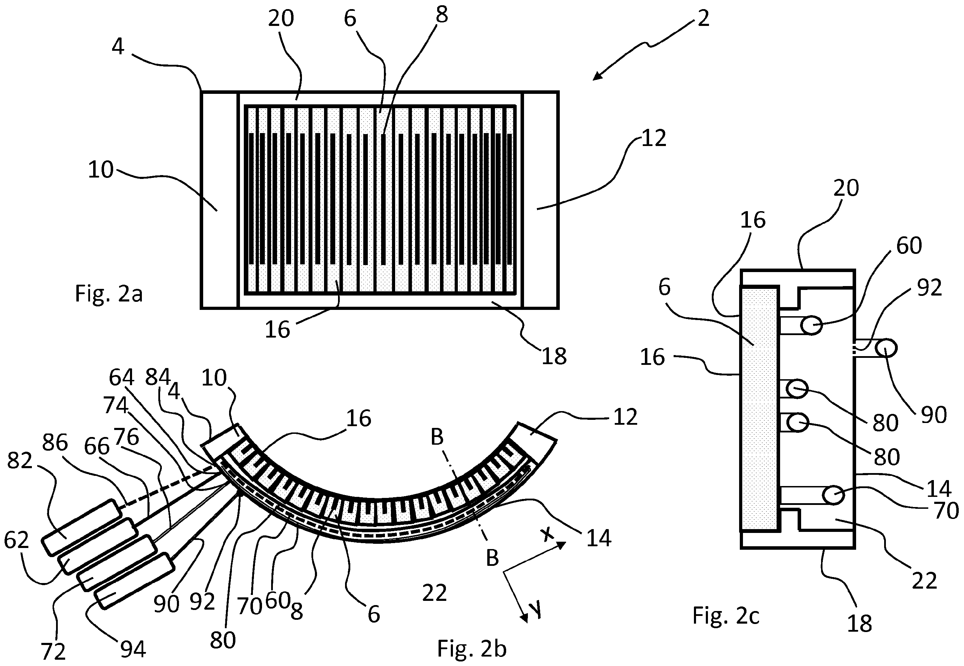

Figure 2a shows an output face 16 of a nozzle head 2 according to the invention. The figure shows that the nozzle head 2 comprises a body 4 comprising a first side structure 10, a second side structure 12 opposite to the first side structure 10 and a first end structure 18 and a second end structure 20 opposite to the first end structure 18. The nozzles 6 are arranged to extend between the first and second end structures 18, 20 and arranged adjacent to each other in a direction between the first and second side structures 10, 12. The nozzles 6 comprise a precursor supply channel 8 for supplying precursor gases via the output face 16 toward a surface of a substrate.

Figure 2b shows an embodiment of the nozzle head 2 according to the invention which the nozzle head 2 is formed as a curved nozzle head 2 and the output face 16 is arranged on the upper surface of the nozzle head 2. The curved nozzle head 2 is typically provided with a transport cylinder or a curved transport surface for transferring a substrate. The nozzle head 2 comprises similarly as explained in connection with figure 1a a nozzle head chamber 22 provided with a purge gas inlet 92 for supplying gas into the nozzle head chamber 22 from a gas source 94 outside the nozzle head 2. In the embodiment shown in figure 2b the top structure 14 of the nozzle head 2 faces downwards as the output face 16 faces upwards but the purge gas inlet 92 is in this embodiment too arranged in the top structure 14 of the nozzle head 2 such that gas supplied from the gas source 94 via a gas channel 90 is supplied from the top of the nozzle head chamber 22 to the nozzle head chamber 22. The purge gas inlet 92 comprises a gas supply opening which is open to the inner space of the nozzle head chamber and is connected to a gas source 94 arranged outside the nozzle head 2. The nozzle head chamber 22 is further provided with a first precursor conduit 60, a second precursor conduit 70 and two discharge conduits 80 extending inside the nozzle head chamber 22 between the nozzles 6 and the respective gas connections 64, 74, 84. The first precursor conduit 60 for distributing first precursor gas to at least one of the two or more nozzles 6 is connected to the first precursor gas connection 64, the second precursor conduit 70 for distributing second precursor gas to at least one of the two or more nozzles 6 is connected to the second precursor gas connection 74 and the two discharge conduits 80 for discharging gases from the surface of the substrate through the output face of the nozzle head 2 and through the at least one of the two or more nozzles 6 are connected to the discharge gas connection 84. For the two discharge conduits 80 there can be one or two discharge gas connections 84 such that each discharge conduit 80 is connected to one discharge gas connection 84. Accordingly, there can be a common discharge system 82 for all the discharge conduits 80 or alternatively each discharge conduit 80 is connected to an own discharge system 82 through a discharge channel 86 extending outside the nozzle head 2. Figure 2b does not show in detail the precursor conduits or the discharge conduit but they are similarly as described in connection with figure 1a branching conduits such that the conduit 60, 70 is connected with a single gas connection 64, 74 to the source 62, 72 arranged outside the nozzle head 2 and inside the nozzle head chamber 22 the conduit 60, 70 is divided into several branches for making connections with several nozzles 6. The first precursor source 62, the second precursor source 72, the purge gas source 94 and the discharge system 82 preferably comprising a pump or other discharging means are provided outside the nozzle head 2 and connected to the nozzle head 2 with channels 66, 76, 86, 90 extending between the nozzle head 2 and the sources 62, 72, 94 or between the nozzle head 2 and the system 82.

Figure 2c shows a cross section of the nozzle head along line B-B shown in figure 2b. Figure 2c shows that a nozzle 6 is arranged to extend between the first and second end structures 18, 20. The nozzle head chamber 22 is provided with a purge gas inlet 92 such that purge gas supplied from a purge gas channel to the interior of the nozzle chamber 22 through the purge gas inlet 92 and is spread into the nozzle head chamber 22. The nozzle head chamber 22 is in fluid communication with the nozzles 6 and the purge gas spread in the nozzle head chamber 22 is flown via the nozzles 6 to the output face 16 of the nozzle head 2. The first precursor conduit 60, the second precursor conduit 70 and the two discharge conduits 80 are arranged inside the nozzle head chamber 22 such that they each extend between the nozzles 6 and a single gas connection provided in the top 14 of the nozzle head chamber 22 or in the side walls of the nozzle head chamber 22.

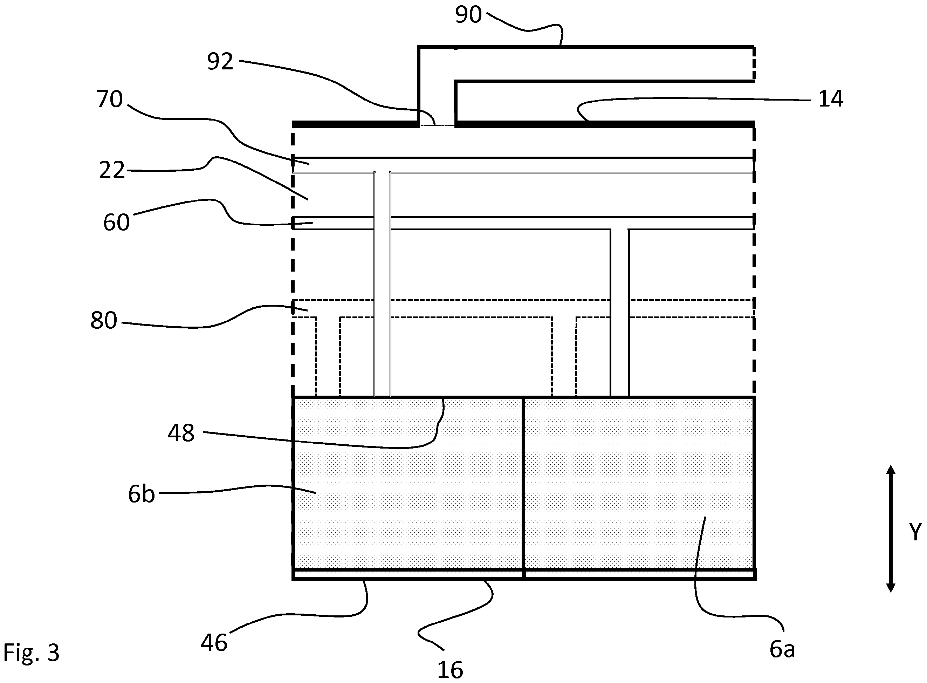

Figure 3 shows a detail indicated with letter C of the nozzle head 2 shown in figure 1a. Figure 3 shows that two nozzles 6 are arranged adjacent to each other. There is a first precursor nozzle 6a for supplying first precursor gas and a second precursor nozzle 6b for supplying second precursor gas. The first and second precursor nozzles 6a, 6b comprise a nozzle output surface 48 which forms the nozzle head 2 output face 16 via which the precursor gases are supplied toward the surface of the substrate. The nozzle head chamber 22 is formed between the top structure 14 of the nozzle head 2 and the nozzle top surface 48 in the height direction of the nozzle head 2. The purge gas inlet 92, preferably the purge gas inlet 92, is arranged in this embodiment of the invention to the top structure 14 of the nozzle head 2 for providing a gas supply opening which is open to the inner space of the nozzle head chamber 22. The purge gas channel 90 extending from the purge gas source (not shown in figure 3) is connected to the purge gas inlet 92 for providing purge gas from the purge gas source. Although the channel 90 is named as the purge gas channel 90 other gases such as precursor gases can also be supplied through the gas channel 90 in situations where the nozzle head chamber 22 is more preferably provided with precursor gas than purge gas.

In the detail shown in figure 3 the first precursor nozzle 6a is connected to the first precursor conduit 60 for providing first precursor gas to the nozzle 6 and the second precursor nozzle 6b is connected to the second precursor conduit 70 for providing second precursor gas to the nozzle 6. The discharge conduit 80 is connected to both nozzles 6, i.e. to the first precursor nozzle 6a and to the second precursor nozzle 6b. The discharge conduit 80 is a distributor conduit having several branches for connecting with several nozzles 6 and having a single gas connection out from the nozzle head 2. The first precursor conduit 60 and the second precursor conduit 70 are similarly branching conduits that connect to several nozzles 6 but having a single gas connection out from the nozzle head 2.

Although the figures show for the sake of clarity only on discharge conduit 82 there may alternatively be several discharge conduits, for example in the case where there are two precursor gas conduits there can be also two discharge conduits such that there is one discharge for each precursor gas.

The invention has been described above with reference to the examples shown in the figures. However, the invention is in no way restricted to the above examples but may vary within the scope of the claims.

## Claims

1. A nozzle head (2) for subjecting a surface of a substrate to successive surface reactions of at least two precursor gases according to the principles of atomic layer deposition, the nozzle head (2) comprising:
- a body (4);
- an output face (16) via which at least one precursor gas is supplied towards the surface of the substrate; and
- two or more nozzles (6) provided in connection with the output face (16) for supplying the at least one precursor gas,
**characterized in that** the nozzle head (2) further comprises a nozzle head chamber (22) inside the body (4) of the nozzle head (2), said nozzle head chamber (22) is arranged in fluid communication with the two or more nozzles (6), the nozzle head chamber (22) is provided with a purge gas inlet (92) for supplying purge gas into the nozzle head chamber (22) from a purge gas source (94) outside the nozzle head (2),
the nozzle head chamber (22) comprises a first precursor conduit (60) for distributing first precursor gas to at least one of the two or more nozzles (6).

2. A nozzle head (2) according to claim 1, **characterized in that** the body (4) comprises a first side structure (10), a second side structure (12), a first end structure (18) and a second end structure (20), and that the two or more nozzles (6) are arranged to extend between the first and second end structures (18, 20) and arranged adjacent to each other in a direction between the first and second side structures (10, 12).

3. A nozzle head (2) according to claim 2, **characterized in that** the nozzle head chamber (22) is arranged inside the body (4) of the nozzle head (2), and that:
the two or more nozzles (6) are arranged to form at least part of a bottom wall of the nozzle head chamber (22), and
the first side structure (10), the second side structure (12), the first end structure (18) and the second end structure (20) of the body (4) are arranged to form side walls of the nozzle head chamber (22), and
the body (4) further comprises a top structure (14) forming a top wall of the nozzle head chamber (22).

4. A nozzle head (2) according to claim 1, **characterized in that** the nozzle head (2) comprises a first precursor gas connection (64) for connecting a first precursor channel (66) arranged outside the nozzle head (2) and extending from a first precursor source (62) with the first precursor conduit (60) arranged inside the nozzle head chamber (22) and extending to the at least one of the two or more nozzles (6).

5. A nozzle head (2) according to any previous claim, **characterized in that** the nozzle head chamber (22) comprises a second precursor conduit (70) for distributing second precursor gas to at least one of the two or more nozzles (6).

6. A nozzle head (2) according to claim 5, **characterized in that** the nozzle head (2) comprises a second precursor gas connection (74) for connecting a second precursor channel (76) arranged outside the nozzle head (2) and extending from a second precursor source (72) with the second precursor conduit (70) arranged inside the nozzle head chamber (2) and extending to the at least one of the two or more nozzles (6).

7. A nozzle head (2) according to any previous claim, **characterized in that** the purge gas inlet (92) is arranged to form a gas connection with a purge gas channel (90) arranged outside the nozzle head (2) and extending between the purge gas inlet (92) and the purge gas source (94), said purge gas inlet (92) is arranged to provide a fluid connection between the purge gas source (94) and the nozzle head chamber (22).

8. A nozzle head according to any previous claim, **characterized in that** the nozzle head chamber (22) comprises a discharge conduit (80) for discharging gases from the surface of the substrate through the output face of the nozzle head (2) and through the at least one of the two or more nozzles (6), said discharge conduit (80) is connected to a discharge system (82) arranged outside the nozzle head (2).

9. A nozzle head according to claim 8, **characterized in that** the nozzle head (2) comprises a discharge gas connection (84) for connecting a discharge channel (86) arranged outside the nozzle head (2) and extending from the discharge system (82) with the discharge conduit (80) arranged inside the nozzle head chamber (22).

10. A nozzle head (2) according to any previous claim, **characterized in that** the nozzle head (2) comprises two or more first precursor nozzles (6a) for supplying first precursor gas and two or more second precursor nozzles (6b) for supplying second precursor gas.

## Patentansprüche

1. Düsenkopf (2), um eine Oberfläche eines Substrats gemäß den Prinzipien von Atomlagenabscheidung aufeinanderfolgenden Oberflächenreaktionen von zumindest zwei Vorläufergasen zu unterziehen, wobei der Düsenkopf (2) Folgendes umfasst:
- einen Körper (4);
- eine Ausgangsfläche (16), über die mindestens ein Vorläufergas der Oberfläche des Substrats zugeführt wird; und
- zwei oder mehr Düsen (6), die in Verbindung mit der Ausgangsfläche (16) zum Zuführen des zumindest einen Vorläufergases vorgesehen sind;
**dadurch gekennzeichnet, dass** der Düsenkopf (2) weiter eine Düsenkopfkammer (22) innerhalb des Körpers (4) des Düsenkopfs (2) umfasst, die Düsenkopfkammer (22) in strömungstechnischer Kommunikation mit den zwei oder mehr Düsen (6) angeordnet ist, die Düsenkopfkammer (22) mit einem Spülgaseinlass (92) zum Zuführen von Spülgas in die Düsenkopfkammer (22) von einer Spülgasquelle (94) außerhalb des Düsenkopfs (2) versehen ist;
die Düsenkopfkammer (22) eine erste Vorläuferleitung (60) zum Verteilen von erstem Vorläufergas an mindestens eine der zwei oder mehr Düsen (6) umfasst.

2. Düsenkopf (2) nach Anspruch 1, **dadurch gekennzeichnet, dass** der Körper (4) eine erste Seitenstruktur (10), eine zweite Seitenstruktur (12), eine erste Endstruktur (18) und eine zweite Endstruktur (20) umfasst, und dass die zwei oder mehr Düsen (6) dazu angeordnet sind, sich zwischen der ersten und der zweiten Endstruktur (18, 20) zu erstrecken und angrenzend aneinander in einer Richtung zwischen der ersten und zweiten Seitenstruktur (10, 12) angeordnet sind.

3. Düsenkopf (2) nach Anspruch 2, **dadurch gekennzeichnet, dass** die Düsenkopfkammer (22) innerhalb des Körpers (4) des Düsenkopfs (2) angeordnet ist, und dass:
die zwei oder mehr Düsen (6) angeordnet sind, mindestens einen Teil einer Bodenwand der Düsenkopfkammer (22) zu bilden, und
die erste Seitenstruktur (10), die zweite Seitenstruktur (12), die erste Endstruktur (18) und die zweite Endstruktur (20) des Körpers (4) angeordnet sind, Seitenwände der Düsenkopfkammer (22) zu bilden, und
der Körper (4) weiter eine Deckstruktur (14) umfasst, die eine Deckwand der Düsenkopfkammer (22) bildet.

4. Düsenkopf (2) nach Anspruch 1, **dadurch gekennzeichnet, dass** der Düsenkopf (2) eine erste Vorläufergasverbindung (64) zum Verbinden eines ersten Vorläuferkanals (66), der außerhalb des Düsenkopfs (2) angeordnet ist und sich von einer ersten Vorläuferquelle (62) erstreckt, mit der ersten Vorläuferleitung (60) umfasst, die innerhalb der Düsenkopfkammer (22) angeordnet ist und sich zu der mindestens einen der zwei oder mehr Düsen (6) erstreckt.

5. Düsenkopf (2) nach einem vorstehenden Anspruch, **dadurch gekennzeichnet, dass** die Düsenkopfkammer (22) eine zweite Vorläuferleitung (70) zum Verteilen von zweitem Vorläufergas an mindestens eine der zwei oder mehr Düsen (6) umfasst.

6. Düsenkopf (2) nach Anspruch 5, **dadurch gekennzeichnet, dass** der Düsenkopf (2) eine zweite Vorläufergasverbindung (74) zum Verbinden eines zweiten Vorläuferkanals (76), der außerhalb des Düsenkopfs (2) angeordnet ist und sich von einer zweiten Vorläuferquelle (72) erstreckt, mit der zweiten Vorläuferleitung (70) umfasst, die innerhalb der Düsenkopfkammer (2) angeordnet ist und sich zu der mindestens einen der zwei oder mehr Düsen (6) erstreckt.

7. Düsenkopf (2) nach einem vorstehenden Anspruch, **dadurch gekennzeichnet, dass** der Spülgaseinlass (92) angeordnet ist, eine Gasverbindung mit einem Spülgaskanal (90) zu bilden, der außerhalb des Düsenkopfs (2) angeordnet ist und sich zwischen dem Spülgaseinlass (92) und der Spülgasquelle (94) erstreckt, wobei der Spülgaseinlass (92) angeordnet ist, eine Fluidverbindung zwischen der Spülgasquelle (94) und der Düsenkopfkammer (22) vorzusehen.

8. Düsenkopf nach einem vorstehenden Anspruch, **dadurch gekennzeichnet, dass** die Düsenkopfkammer (22) eine Ausstoßleitung (80) zum Ausstoßen von Gasen von der Oberfläche des Substrats durch die Ausgangsfläche des Düsenkopfs (2) und durch die mindestens eine der zwei oder mehr Düsen (6) umfasst, wobei die Ausstoßleitung (80) mit einem Ausstoßsystem (82) verbunden ist, das außerhalb des Düsenkopfs (2) angeordnet ist.

9. Düsenkopf nach Anspruch 8, **dadurch gekennzeichnet, dass** der Düsenkopf (2) eine Ausstoßgasverbindung (84) zum Verbinden eines Ausstoßkanals (86), der außerhalb des Düsenkopfs (2) angeordnet ist und sich von dem Ausstoßsystem (82) erstreckt, mit der Ausstoßleitung (80) umfasst, die innerhalb der Düsenkopfkammer (22) angeordnet ist.

10. Düsenkopf (2) nach einem vorstehenden Anspruch, **dadurch gekennzeichnet, dass** der Düsenkopf (2) zwei oder mehr erste Vorläuferdüsen (6a) zum Zuführen von erstem Vorläufergas und zwei oder mehr zweite Vorläuferdüsen (6b) zum Zuführen von zweitem Vorläufergas umfasst.

## Revendications

1. Tête de buse (2) destinée à soumettre une surface d'un substrat à des réactions de surface successives d'au moins deux gaz précurseurs en fonction des principes de dépôt de couches atomiques, la tête de buse (2) comprenant :
- un corps (4) ;
- une face de sortie (16) par l'intermédiaire de laquelle au moins un gaz précurseur est fourni vers la surface du substrat ; et
- deux buses ou plus (6) fournies raccordées à la face de sortie (16) pour fournir le au moins un gaz précurseur,
**caractérisée en ce que** la tête de buse (2) comprend en outre une chambre de tête de buse (22) à l'intérieur du corps (4) de la tête de buse (2), ladite chambre de tête de buse (22) est agencée en communication fluidique avec les deux buses ou plus (6), la chambre de tête de buse (22) est pourvue d'une entrée de gaz de purge (92) pour fournir du gaz de purge dans la chambre de tête de buse (22) à partir d'une source de gaz de purge (94) à l'extérieur de la tête de buse (2),
la chambre de tête de buse (22) comprend un premier conduit de précurseur (60) pour distribuer le premier gaz précurseur à au moins l'une des deux buses ou plus (6).

2. Tête de buse (2) selon la revendication 1, **caractérisée en ce que** le corps (4) comprend une première structure latérale (10), une seconde structure latérale (12), une première structure d'extrémité (18) et une seconde structure d'extrémité (20), et **en ce que** les deux buses ou plus (6) sont agencées pour s'étendre entre les première et seconde structures d'extrémité (18, 20) et agencées de manière adjacente les unes aux autres dans une direction entre les première et seconde structures latérales (10, 12).

3. Tête de buse (2) selon la revendication 2, **caractérisée en ce que** la chambre de tête de buse (22) est agencée à l'intérieur du corps (4) de la tête de buse (2), et **en ce que** :
les deux buses ou plus (6) sont agencées pour former au moins une partie d'une paroi inférieure de la chambre de tête de buse (22), et
la première structure latérale (10), la seconde structure latérale (12), la première structure d'extrémité (18) et la seconde structure d'extrémité (20) du corps (4) sont agencées pour former des parois latérales de la chambre de tête de buse (22), et
le corps (4) comprend en outre une structure supérieure (14) formant une paroi supérieure de la chambre de tête de buse (22).

4. Tête de buse (2) selon la revendication 1, **caractérisée en ce que** la tête de buse (2) comprend un premier raccord de gaz précurseur (64) pour raccorder un premier canal de précurseur (66) agencé à l'extérieur de la tête de buse (2) et s'étendant à partir d'une première source de précurseur (62) avec le premier conduit de précurseur (60) agencé à l'intérieur de la chambre de tête de buse (22) et s'étendant jusqu'à la au moins une des deux buses ou plus (6).

5. Tête de buse (2) selon une quelconque revendication précédente, **caractérisée en ce que** la chambre de tête de buse (22) comprend un second conduit de précurseur (70) pour distribuer un second gaz précurseur à au moins l'une des deux buses ou plus (6).

6. Tête de buse (2) selon la revendication 5, **caractérisée en ce que** la tête de buse (2) comprend un second raccord de gaz précurseur (74) pour raccorder un second canal de précurseur (76) agencé à l'extérieur de la tête de buse (2) et s'étendant à partir d'une seconde source de précurseur (72) avec le second conduit de précurseur (70) agencé à l'intérieur de la chambre de tête de buse (2) et s'étendant jusqu'à la au moins une des deux buses ou plus (6).

7. Tête de buse (2) selon une quelconque revendication précédente, **caractérisée en ce que** l'entrée de gaz de purge (92) est agencée pour former un raccord de gaz avec un canal de gaz de purge (90) agencé à l'extérieur de la tête de buse (2) et s'étendant entre l'entrée de gaz de purge (92) et la source de gaz de purge (94), ladite entrée de gaz de purge (92) est agencée pour fournir une connexion fluidique entre la source de gaz de purge (94) et la chambre de tête de buse (22).

8. Tête de buse selon une quelconque revendication précédente, **caractérisée en ce que** la chambre de tête de buse (22) comprend un conduit de décharge (80) pour décharger des gaz de la surface du substrat à travers la face de sortie de la tête de buse (2) et à travers la au moins une des deux buses ou plus (6), ledit conduit de décharge (80) est raccordé à un système de décharge (82) agencé à l'extérieur de la tête de buse (2).

9. Tête de buse selon la revendication 8, **caractérisée en ce que** la tête de buse (2) comprend un raccord de gaz de décharge (84) pour raccorder un canal de décharge (86) agencé à l'extérieur de la tête de buse (2) et s'étendant à partir du système de décharge (82) avec le conduit de décharge (80) agencé à l'intérieur de la chambre de tête de buse (22).

10. Tête de buse (2) selon une quelconque revendication précédente, **caractérisée en ce que** la tête de buse (2) comprend deux premières buses de précurseur ou plus (6a) pour fournir le premier gaz précurseur et deux secondes buses de précurseur ou plus (6b) pour fournir le second gaz précurseur.
